# EUROPÄISCHE PATENTSCHRIFT

(11) **EP 3 891 891 B1**
(45) Veröffentlichungstag und Bekanntmachung des Hinweises auf die Patenterteilung: **24.05.2023**
(21) Anmeldenummer: 20706961.8
(22) Anmeldetag: 12.02.2020
(51) Int. Cl.: H03K 17/082, H03K 17/12

(54) **SCHALTMODUL FÜR EINEN ELEKTRONISCHEN SCHALTER**
SWITCH MODULE FOR AN ELECTRICAL SWITCH
MODULE DE COMMUTATION POUR UN COMMUTATEUR ÉLECTRONIQUE

(30) Priorität: 14.02.2019 EP 19157154
(43) Veröffentlichungstag der Anmeldung: 13.10.2021
(73) Patentinhaber: Siemens Aktiengesellschaft, 80333 München (DE)
(72) Erfinder: BÖKE, Willi, 91207 Lauf (DE); GAUDENZ, Markus Matthias, 91056 Erlangen (DE)
(74) Vertreter: Siemens Patent Attorneys
(86) Internationale Anmeldenummer: PCT/EP2020/053526
(87) Internationale Veröffentlichungsnummer: WO 2020/165202

(56) Entgegenhaltungen:
- EP-A1- 2 445 110
- US-A1- 2006 193 091
- US-A1- 2017 054 439
- HOFER P ET AL: "Paralleling intelligent IGBT power modules with active gate-controlled current balancing", POWER ELECTRONICS SPECIALISTS CONFERENCE, 1996. PESC '96 RECORD., 27TH ANNUAL IEEE; [PESC RECORD: ANNUAL IEEE POWER ELECTRONICS SPECIALISTS CONFERENCE. FORMERLY POWER CONDITIONING SPECIALISTS CONFEREN , 23. Juni 1996 (1996-06-23), XP002619276, ISBN: 978-0-7803-3501-1 Gefunden im Internet: URL:http://ieeexplore.ieee.org/stamp/stamp .jsp?tp=&arnumber=548751&tag=1 [gefunden am 2011-01-28]

## Beschreibung

Die Erfindung betrifft einen elektronischen Schalter. Ferner betrifft die Erfindung ein Verfahren zum Betreiben eines derartigen elektronischen Schalters.

Ein Schalter wird auch als Schaltgeräte bezeichnet. Schalter für hohe Ströme, insbesondere mechanische Schalter, sind aufwendiger in der Herstellung, gerade wenn es sich um Gleichspannungsschalter handelt. Aufgrund der geringen Stückzahlen, die mit der Höhe des zu schaltenden Stroms sinken, sind diese Schalter für hohe Ströme im Vergleich zu kleineren Ausführungen entsprechend überproportional teurer. Dabei werden Schalter heutzutage in erster Linie auf die zu schaltende Last ausgelegt.

Neben den mechanischen Schaltern sind auch elektronische Schalter bekannt. Ein elektronischer Schalter weist einen Halbleiterschalter auf, der den Strom durch den elektronischen Schalter führt oder unterbricht. Diese elektronischen Schalter sind in der Lage, schnell zu schalten.

Große Ströme können durch Parallelschalten von mechanischen Schaltern, beispielsweise durch das betriebsmäßige Schalten von Schützen, beherrscht werden. Allerdings ist dieser Parallelbetrieb heutzutage nicht ohne weitere Maßnahmen möglich. So werden dann für die Schutzfunktion zusätzliche Schutzrelais (Messeinrichtungen und Überwachungen) eingesetzt, die die Schaltgeräte dann kontrollieren. Bei der Parallelschaltung von mechanischen Schaltern sind entsprechend Abschläge (10% bis 30%) für eventuelle Asymmetrien in der Stromverteilung zu berücksichtigen. Eine Parallelschaltung über zwei mechanische Schalter hinaus ist auf Grund der großen Abschläge nicht mehr sinnvoll. Zusätzlich müssen aufwendige Konstruktionen für die Zusammenschaltung der Strombahnen eingesetzt werden, da kleine Schaltgeräte nicht den für den Summenstrom nötigen Querschnitt aufnehmen können. Die einzelnen Leiterzuführungen müssen ebenfalls sehr symmetrisch ausgeführt werden, damit die Stromaufteilung gleichmäßig erfolgt. Gleichzeitig sind hohe Anforderungen an ein synchrones Schalten zu erfüllen, damit es nicht bei einer Schalthandlung zu Überlastungen an einem der parallelen Schaltern kommt.

Halbleiter weisen einen Durchlasswiderstand auf. Das ist ein elektrischer Widerstand zwischen den Schaltanschlüssen des Halbleiters. Fließt ein Strom durch den Halbleiter so entsteht unter anderem aufgrund des Durchlasswiderstands ein Spannungsabfall über den Schaltanschlüssen. Gleichzeitig entstehen aufgrund des Durchlasswiderstands abhängig vom Strom Verluste im Halbleiter.

Der elektronische Schalter hat die Aufgabe, die mindestens zwei vorhandenen Anschlüsse mittels eines oder mehrerer Halbleiterschalter elektrisch voneinander zu trennen, um einen Stromfluss zu verhindern oder elektrisch miteinander zu verbinden, um einen Stromfluss zu ermöglichen. Beispiele für die Realisierung eines derartigen elektronischen Schalters sind in der WO 2019/011642 A1 angegeben. Der elektronische Schalter ist nicht zu verwechseln mit einem Schaltelement eines Stromrichters. Auch kommen dort als Schaltelemente Halbleiter zum Einsatz, die benötigt werden, eine vorgebbare Spannung zu erzeugen. Ein derartiges Schaltelement eines Stromrichters ist jedoch nicht ohne Weiteres als elektronischer Schalter verwendbar.

Die Leistungsfähigkeit eines Schalters bemisst sich daran, welchen Strom der Schalter schalten kann. Je größer der schaltbare Strom desto größer ist die Leistungsfähigkeit des Schalters. Man sagt dazu auch, die Schaltleistung des Schalters ist größer.

Ein Schalter, insbesondere ein elektronischer Schalter, haben die Aufgabe eine leitende Verbindung zu schaffen oder diese zu unterbrechen. Dabei wird in einem EIN Zustand, auch als eingeschalteter Zustand oder leitender Zustand bezeichnet, eine leitende Verbindung geschaffen, während im AUS Zustand, auch als ausgeschalteter Zustand oder nichtleitender Zustand bezeichnet, die Eingangs- und Ausgangsanschlüsse des Schalters voneinander elektrisch isoliert sind. Die Umschaltung zwischen EIN und AUS Zustand erfolgt im mechanischen Schalter durch die Bewegung eines stromleitenden Elements, im elektronischen Schalter durch die Ansteuerung eines oder mehrerer Halbleiter.

Aus der EP 2 445 110 A1 ist eine intelligente Gate-Treiberschaltung mit verteilter Intelligenz bekannt. Diese wird verwendet, um parallel geschaltete elektrische Schaltgeräte wie IGBTs zu steuern. Zweck der Intelligenz ist es, die Ströme der Schaltgeräte auch bei dynamischen Schaltvorgängen zu symmetrieren.

Aus der Veröffentlichung "Paralleling intelligent IGBT power moduls with active gate-controlles current balancing" (von Hofer, P.; Karrer, N. und Gerster, Ch.; 23. Juni 1996, XP002619276) ist ein Regelkreis bekannt, der den Strom einer beliebigen Zahl paralleler Leistungsmodule symmetrieren kann.

Der Erfindung liegt die Aufgabe zugrunde, einen elektronischen Schalter zu verbessern.

Diese Aufgabe wird durch einen elektronischen Schalter mit den Merkmalen des Anspruchs 1 gelöst. Diese Aufgabe wird ferner durch ein Verfahren zum Betreiben eines derartigen elektronischen Schalters mit den Merkmalen des Anspruchs 6 gelöst.

Weitere vorteilhafte Ausgestaltungen der Erfindung sind in den abhängigen Ansprüchen angegeben.

Der Erfindung liegt die Erkenntnis zugrunde, dass sich ein elektronischer Schalter besonders günstig herstellen lässt, wenn dieser modular aufgebaut ist. Bei dem modularen Aufbau setzt sich der elektronische Schalter aus einer Parallelschaltung von Schaltmodulen zusammen, wobei jedes Schaltmodul einen Halbleiterschalter aufweist. Der Strom durch den elektronischen Schalter teilt sich dabei auf die parallelen Halbleiterschalter auf.

Der Halbleiterschalter kann dabei einen oder mehrere Halbleiter aufweisen. Der jeweilige Halbleiter wiederum weist ein schaltendes Element und weist, je nachdem ob er rückwärts leitfähig oder sperrend ausgebildet ist, gegebenenfalls eine zum schaltenden Element antiparallel angeordnete Diode auf.

Dabei wird im eingeschalteten Zustand des Schaltmoduls mittels der Ansteuerschaltung in Abhängigkeit von über die Datenschnittstelle ausgetauschten Daten und in Abhängigkeit von Messwerten des Stromsensors der Durchlasswiderstand des Halbleiterschalters verändert, da sich gerade stationär eine ungleiche Stromverteilung in einem elektronischen Schalter mit mehreren parallelen Schaltmodulen ergeben kann.

Dabei hängt die Variation des Durchlasswiderstands von Daten ab, die über die Schnittstelle ausgetauscht werden. Beispielsweise kann eine übergeordnete Regelung an die einzelnen Schaltmodule Daten übertragen, in welcher Höhe der Durchlasswiderstand einzustellen ist. Weiter erfolgt die Variation des Durchlasswiderstandes auch in Abhängigkeit vom Strommesswert. So kann beispielsweise eine hinterlegte Kennlinie die Höhe des einzustellenden Durchlasswiderstands in Abhängigkeit von dem Strom durch das Schaltmodul festgelegt werden. Auch dadurch lässt sich eine gute und gleichmäßige Aufteilung des Stroms durch den elektronischen Schalter auf die Schaltmodule erzielen. Folglich wird die Variation sowohl in Abhängigkeit von Daten, die über die Datenschnittstelle ausgetauscht werden, als auch von Strommesswerten durchgeführt. Beispielsweise kann über die Datenschnittstelle als Werte Strommesswerte anderer Schaltmodule übertragen werden. Wenn sowohl die Stromwerte paralleler Schaltmodule als auch der Stromwert durch das vorliegende Schaltmodul bekannt ist, kann auf besonders einfache Weise eine vorgebbare Stromaufteilung bei geringen Durchlasswiderständen realisiert werden. Insbesondere eine gleichmäßige Aufteilung des Stroms durch den elektronischen Schalter auf die parallelen Schaltmodule kann besonders einfach erfolgen, da die Regelgröße und somit die Regelabweichung jedem Schaltmodul bekannt ist.

Die Anzahl der Gleichteile, wie gleichartige Schaltmodule oder gleichartige Komponenten in den Schaltmodulen, wie beispielsweise die Datenschnittstelle oder die Ansteuerschaltung, ist groß und es lassen sich damit elektronische Schalter mit unterschiedlichem Leistungsvermögen auf einfache Weise herstellen. Dazu werden unterschiedlich viele Schaltmodule parallelgeschaltet. Gerade auch elektronischer Schalter mit großen Schaltströmen lassen sich durch den modular aufgebauten elektronischen Schalter kostengünstig realisieren.

Die Parallelschaltung von Schaltmodulen und damit die Parallelschaltung von Halbleiterschaltern wird unter anderem durch eine Datenschnittstelle der Schaltmodule ermöglicht. Über diese Datenschnittstelle tauschen die parallel angeordneten Schaltmodule eine Information über ihren Modulzustand aus. Dies kann beispielsweise eine Information über einen gemessenen Strom, eine Information zu dem Überschreiten eines Grenzwertes, insbesondere das Überschreiten des für den Halbleiterschalter zulässigen Stroms, eine Information über die Auslastung des Halbleiterschalters oder über die Verlustleitung des Halbleiterschalters sein. Diese Information wird dazu genutzt, die Aufteilung des Stroms durch den elektronischen Schalter auf die parallel angeordneten Halbleiterschalter zu beeinflussen. Dazu kann neben der Information oder den Informationen der parallel angeordneten Schaltmodule auch der Strommesswert des eigenen Schaltmoduls herangezogen werden. Die Aufteilung des Stroms des elektronischen Schalters erfolgt durch die Ansteuerschaltungen der jeweiligen Schaltmodule, die den Durchlasswiderstand der einzelnen Halbleiterschalter verändert und damit auch die Aufteilung des Stroms auf die einzelnen Schaltmodule beeinflusst. Damit ist die Aufteilung des Stroms auf die einzelnen Schaltmodule durch die Ansteuerschaltung steuerbar oder regelbar.

Für die Aufteilung des Stroms können unterschiedliche Kriterien zur Anwendung kommen. Durch die Regelung oder Steuerung wird sichergestellt, dass die Aufteilung derart erfolgt, dass keiner der parallel angeordneten Halbleiterschalter mit einem unzulässig hohen Strom belastet wird. Mit anderen Worten wird die Aufteilung so geregelt oder gesteuert, dass der Strom durch den Halbleiterschalter maximal den für diesen Halbleiterschalter maximal zulässigen Wert annimmt und der Halbleiterschalter nicht überlastet wird. Dieser Strom kann vorgegeben werden, beispielsweise aus einem Datenblatt des Halbleiterschalters, oder mit Hilfe eines Modells kontinuierlich berechnet werden, wobei beispielsweise die Verlustleitung oder die Temperatur des Halbleiterschalters eingeht. Darüber hinaus hat es sich als vorteilhaft erwiesen, dass der Strom sich gleichmäßig auf die parallelen Halbleiterschalter aufteilt. Dies ist insbesondere dann vorteilhaft, wenn die Schaltmodule baugleich ausgeführt sind. Dann entspricht die gleichmäßige Aufteilung auch einer gleichmäßigen Belastung der Schaltmodule. Durch den Stromsensor kann eine entsprechende Regelung einfach realisiert werden. Alternativ ist es möglich, den Strom derart aufzuteilen, dass die Verlustleistung in den einzelnen Schaltmodulen gleich ist. Damit ist auch die entstehende Wärme gleichmäßig über die Schaltmodule verteilt und kann einfach an die Umgebung abgegeben werden. Die Gefahr von punktueller Erwärmung, die zur Beschädigung oder zu einer Verkürzung der Lebensdauer einzelner Schaltmodule führen kann, kann durch die gleichmäßige Verlustleistung vermieden werden.

Die Abweichungen aufgrund Unterschiede in den einzelnen parallel angeordneten Halbleiterschaltern und die Unterschiede in den Leitungswiderständen, beispielsweise durch einen unsymmetrischen Aufbau der Verdrahtung, können durch die Steuerung des Durchlassverhaltens der einzelnen Halbleiterschalter ausgeregelt werden. Durch eine entsprechende Regelung oder Steuerung ergibt sich dann die gewünschte Aufteilung des Stroms auf die einzelnen Schaltmodule. Damit ergeben sich keine Asymmetrien bei der Stromaufteilung, so dass keine Abschläge bei der Dimensionierung der Parallelschaltung der Schaltmodule des elektronischen Schalters vorgenommen werden müssen. Durch die Messung der Ströme und den Eingriff der Regelung oder Steuerung auf das Durchlassverhalten können damit auch unterschiedliche Ausführungen mit einer Vielzahl von Schaltmodulen parallelgeschaltet werden. Damit lässt sich auf besonders einfache Weise ein modularer elektronischer Schalter mit nahezu beliebigen Schaltströmen aus der Parallelschaltung von Schaltmodulen herstellen. Um eine hohe Bandbreite von Schaltströmen abzudecken, sind dafür nur ein oder zumindest wenige Schaltmodule mit unterschiedlicher Leistungsfähigkeit des Halbleiterschalters erforderlich.

Gemäß der Erfindung, bei Vorliegen eines Fehlers werden die parallel angeordneten Halbleiterschalter mittels der Ansteuerschaltung synchron abgeschaltet, um eine Überlastung eines oder mehrerer Schaltmodule zu verhindern. Dabei ist vorteilhaft, zwischen den beiden Schaltzuständen EIN und AUS des Schalters, einen dritten Zustand vorzusehen, bei dem der Schalter bei einem Wechsel zwischen EIN und AUS sowie einem Wechsel zwischen AUS und EIN kurzfristig, beispielsweise im Zeitbereich von bis zu 1ms, im linearen Bereich betrieben wird. Dadurch kann der aufgeteilte Strom durch die einzelnen Schaltmodule kontrolliert reduziert oder kontrolliert aufgebaut werden. Eine Überlastung, hervorgerufen durch eine geänderte Stromaufteilung aufgrund eines zeitlich versetzten Schaltens der einzelnen parallel angeordneten Halbleiterschalter, wird damit zuverlässig vermieden. Als besonders vorteilhaft hat sich dabei die erfindungsgemäße Zeitdauer von 1µs bis 10µs herausgestellt, um eine Überlastung einzelner parallel angeordneter Halbleiterschalter zu vermeiden und gleichzeitig den verlustbehafteten Betrieb im linearen Bereich möglichst kurz zu gestalten.

Gegenüber einer Parallelschaltung von elektromechanischen Schaltgeräten kann bei dem elektronischen Schalter auf der Basis von parallel angeordneten Schaltmodulen durch die kontinuierliche Beeinflussung des Durchlassverhaltens der einzelnen Halbleiterschalter eine günstige Ausnutzung und sogar eine maximale Ausnutzung aller parallelgeschalteter Schaltmodule erreicht werden. Für Anwendungen mit Schutzfunktionen ist dies erstmalig möglich. Da die einzelnen Schaltmodule aufgrund der steuerbaren bzw. regelbaren Stromaufteilung auf die einzelnen Schaltmodule gut in ihrer Leistungsfähigkeit ausgenutzt werden, sind elektronische Schalter mit hohen Schaltströmen besonders preisgünstig herstellbar. Die Kosten für eine Geräteparallelschaltung können durch die hohe Ausnutzung der Schaltmodule reduziert werden. Dabei können diese einzelnen Schaltmodule beliebig parallelgeschaltet werden, so dass sich hieraus modular ein elektronischer Schalter aufbauen lässt, der einen großen Leistungsbereich abdeckt. Der Anteil an Gleichteilen ist damit besonders hoch und gleichzeitig ist der Schalter besonders gut skalierbar. Dies macht den modularen elektronischen Schalter bei der Herstellung, Lagerhaltung, im Ersatzteilgeschäft usw. besonders kostengünstig.

Durch aktive Beeinflussung des Durchlassverhaltens (beispielsweise mittels der Gate-Spannung) kann der Gesamtstrom gesteuert oder geregelt auf die einzelnen Schaltmodule aufgeteilt werden. Somit kann jedes Schaltmodul bis an seine Belastungsgrenze ausgenutzt werden.

Bei einer vorteilhaften Ausgestaltung der Erfindung ist der Halbleiterschalter derart ausgebildet ist, einen Strom unabhängig von der Stromflussrichtung durch das Schaltmodul abschalten zu können. Für den Fall, dass die Halbleiter des Halbleiterschalters rückwärts leitend sind, weist der Halbleiter parallel zu seinem schaltenden Element eine Diode auf, die einen Strom entgegen der Stromrichtung durch das schaltende Element führen kann. Dann sind das schaltende Element und die Diode antiparallel angeordnet. In diesem Fall sind die Halbleiter des Halbleiterschalters in einer Reihenschaltung derart angeordnet, dass ein Strom mit einer ersten Stromflussrichtung durch das schaltende Element des ersten Halbleiters und durch die Diode des zweiten Halbleiters fließt. Ein entgegengesetzter Strom fließt durch das schaltende Element des zweiten Halbleiterschalters und die Diode des ersten Halbleiterschalters.

Für den Fall, dass die Halbleiter rückwärts sperrend ausgebildet sind, also nur einen Strom in eine Richtung führen und abschalten können, weisen die Halbleiter jeweils nur ein schaltendes Element auf. Eine parallele Diode zum schaltenden Element ist nicht vorhanden. Um einen Strom unabhängig von der Stromflussrichtung durch das Schaltmodul führen und abschalten zu können werden die Halbleiter in einer Parallelschaltung angeordnet. Dabei sind die Halbleiter antiparallel zueinander angeordnet. Das bedeutet, dass ein Strom mit einer ersten Stromflussrichtung durch das schaltende Element des ersten Halbleiters fließt und ein in entgegengesetzter Stromflussrichtung durch das Schaltmodul fließender Strom durch das schaltende Element des zweiten Halbleiters fließt.

Der Vorteil dieser Anordnung liegt darin, auch rückspeisefähige Lasten sicher von einer Energiequelle trennen zu können, wenn der Strom in beide Stromflussrichtungen abschaltbar ist. Darüber hinaus ermöglicht ein derartiger elektronischer Schalter, auch unterschiedliche Energieverteilungsnetze oder Energieübertragungsnetze miteinander trennbar zu verbinden.

Bei einer weiteren vorteilhaften Ausgestaltung der Erfindung sind die Schaltmodule baugleich ausgeführt. Auch elektronische Schalter mit großer Schaltströmen lassen sich kostengünstig auf Basis von standardisierten Schaltmodulen aufbauen. Es können dabei aus gleichen Schaltmodulen eine Vielzahl von elektronischen Schaltern mit unterschiedlicher Leistungsfähigkeit hergestellt werden. Diese standardisierten Schaltmodule können in hoher Stückzahl kostengünstig und qualitativ hochwertig produziert werden. Dies führt zu großen Einspareffekten bei der Bereitstellung und Lagerhaltung von elektronischen Schaltern unterschiedlicher Schaltströme und ermöglicht auch, selbst Schalter für hohe Ströme wirtschaftlich anbieten zu können. Viele Gleichteile und die gute Skalierbarkeit, geringe Lagerhaltungskosten, da keine unterschiedlichen Leistungsklassen mit unterschiedlichen Schaltern vorgehalten werden müssen, senken die Kosten deutlich für den modularen elektronischen Schalter im Vergleich zu einem mechanischen oder nichtmodularen Schalter. Wenn die Schaltmodule alle baugleich ausgeführt sind, erhöht sich die Anzahl der Gleichteile weiter und führt so zu kostengünstigen Lösungen aufgrund des gesteigerten Mengeneffekts.

Bei einer weiteren vorteilhaften Ausgestaltung der Erfindung unterscheiden sich die Schaltmodule durch die Leistungsfähigkeit der jeweiligen Halbleiterschalter. Durch Schaltmodule, die jeweils Halbleiterschalter mit unterschiedlicher Leistungsfähigkeit, insbesondere unterschiedlicher Stromtragfähigkeit, aufweisen, lässt sich mit wenigen parallel angeordneten Schaltmodulen ein breites Leistungsspektrum an elektronischen Schaltern mit unterschiedlicher Leistungsfähigkeit, d.h. mit unterschiedlichen Strömen, erzeugen. Auch wenn sich die Halbleiterschalter in ihrer Leistungsfähigkeit unterscheiden, können die Schaltmodule noch einen hohen Anteil an Gleichteilen aufweisen, da auch für unterschiedliche Halbleiterschalter gleiche Ansteuerschaltungen und gleiche Datenschnittstellen verwendet werden können. Damit wird ein guter wirtschaftlicher Kompromiss zwischen Gleichteilen und erforderlicher Anzahl paralleler Schaltmodule erzielt. Durch die unterschiedliche Leistungsfähigkeit der Schaltmodule lässt sich mit wenigen, parallel angeordneten Schaltmodulen unterschiedliche Leistungsfähigkeiten, d.h. unterschiedlich hohe abschaltbare Ströme, erzielen.

Bei einer weiteren vorteilhaften Ausgestaltung der Erfindung ist eine Verdrahtung zur elektrischen Verbindung der Schaltmodule unsymmetrisch ausgeführt. Durch die gesteuerte oder geregelte Aufteilung des Stroms durch den elektronischen Schalter auf die parallelen Schaltmodule kann ein Aufwand für eine möglichst symmetrische Verdrahtung entfallen. Diese symmetrische Verdrahtung ist bei einer Parallelschaltung von mechanischen Schaltern erforderlich, um einer Ungleichverteilung bei der Aufteilung des Stroms auf die einzelnen parallelen Schalter entgegenzuwirken. Diese symmetrische Verdrahtung ist teuer und erfordert Einbauplatz. Anders formuliert, kann bei der Parallelschaltung von Schaltmodulen auf eine symmetrische Verdrahtung verzichtet werden. Dadurch lässt sich Material für die Ausbildung der Verdrahtung, wie teures Kupfer, sparen. Dies ermöglicht darüber hinaus auch einen höherer Freiheitsgerad in der räumlichen Anordnung der Schaltmodule, da diese nicht von der symmetrischen Verdrahtung abhängt. Somit entfallen die Aufwendungen für eine symmetrische Verdrahtung sowie Randbedingungen für die räumliche Anordnung der Schaltmodule, da auch diese Unterschiede mittels Steuerung der Durchlasswiderstände der Halbleiterschalter ausgeglichen werden können. Somit kann in Kombination mit dem vorgeschlagenem Schaltmodul ein besonders einfacher und kostengünstiger Aufbau des elektronischen Schalters erfolgen.

Bei einer weiteren vorteilhaften Ausgestaltung der Erfindung wird die Aufteilung des Stroms auf die Halbleiterschalter derart gesteuert oder geregelt, dass die Auslastung der Halbleiterschalter, insbesondere ein Halbleiterstrom durch die jeweiligen Halbleiterschalter, gleich ist. Die Auslastung ist das Verhältnis vom Strom, der durch den Halbleiterschalter fließt, und dem zulässigen Strom durch den Halbleiterschalter. Bei baugleichen Halbleiterschaltern ist die gleiche Auslastung mit einem gleichen Strom gleichzusetzen. Hat hingegen ein Halbleiterschalter einen doppelt so hohen zulässigen Strom wie ein anderer Halbleiterschalter, so ist bei gleicher Auslastung der Strom durch diesen Halbleiterschalter auch doppelt so groß wie der Strom durch den anderen Halbleiterschalter. Durch die gleiche Auslastung wird die Belastung für die einzelnen Schaltmodule möglichst gering und gleich gehalten, so dass die sich aus diesem Betrieb die Lebensdauer des elektronischen Schalters optimieren lässt. Darüber hinaus lässt sich die Information über die Auslastung auf einfache Weise durch Normierung des Messwertes des Stromsensors ermitteln.

Als Halbleiterstrom wird der Strom durch den Halbleiter des jeweiligen Schaltmoduls bezeichnet.

Bei einer weiteren vorteilhaften Ausgestaltung der Erfindung werden die für die Aufteilung des Stroms erforderlichen Parameter ermittelt und gespeichert. Damit sich die gewünschte Stromaufteilung durch die Steuerung oder Regelung schnell und korrekt einstellt und kein Halbleiterschalter beim Schaltvorgang zu sehr belastet wird, was erst durch die Regelung wieder ausgeglichen wird, hat es sich als vorteilhaft erwiesen, Parameter zu bestimmen und abzuspeichern, bei denen sich der Strom schon nahezu gewünscht auf die parallelen Schaltmodule aufteilt. Diese Parameter berücksichtigen Unterschiede in den Halbleiterschalter der unterschiedlichen Schaltmodule. Diese Parameter können dann als Startpunkt für das erstmalige Schalten des elektronischen Schalters verwendet werden, da damit schon eine optimierte Aufteilung des Stroms auf die Schaltmodule erreicht wird. Die genaue Aufteilung wird dann mit Wirken der Regelung oder Steuerung erreicht.

Diese initiale Messung kann dabei sowohl automatisiert oder auch beispielsweise durch das Inbetriebsetzungspersonal von Hand vorgenommen werden. Somit ist sichergestellt das auch bei extremen Ungleichverteilungen aufgrund von Bauteilstreuungen und/oder einer unsymmetrischen Verdrahtung sich zum Schaltzeitpunkt, insbesondere beim erstmaligen Schalten, schon eine hinreichend gute Stromaufteilung ergibt.

Im Folgenden wird die Erfindung anhand der in den Figuren dargestellten Ausführungsbeispiele näher beschrieben und erläutert. Es zeigen:
FIG 1 ein Schaltmodul und
FIG 2 einen elektronischen Schalter mit Schaltmodulen.

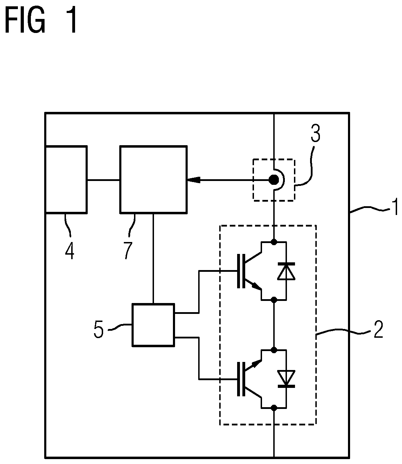

Die FIG 1 zeigt ein Schaltmodul 1, das für die Verwendung in einem modularen elektronischen Schalter 10 geeignet ist. Das Schaltmodul 1 weist einen Halbleiterschalter 2, einen Stromsensor 3, eine Datenschnittstelle 4, eine Ansteuerschaltung 5 und eine Regelung 7 auf. Mit Hilfe des Stromsensors 3 und/oder Daten, die über die Datenschnittstelle von 4 anderen, parallel angeordneten Schaltmodulen 1 übertragbar sind, steuert oder regelt die Regelung 7 den Strom durch das Schaltmodul. Als Stellglied dient dabei das Durchlassverhalten des Halbleiterschalters 2, das mit der Ansteuerschaltung 5 beeinflussbar ist. Dazu tauscht die Regelung 7 mit der Datenschnittstelle 4 Daten aus und/oder empfängt Messwerte vom Stromsensor 3. Der Ausgang der Regelung 7 ist mit der Ansteuerschaltung 5 verbunden, um die Regelungsaufgabe an dem Halbleiterschalter 2 umzusetzen.

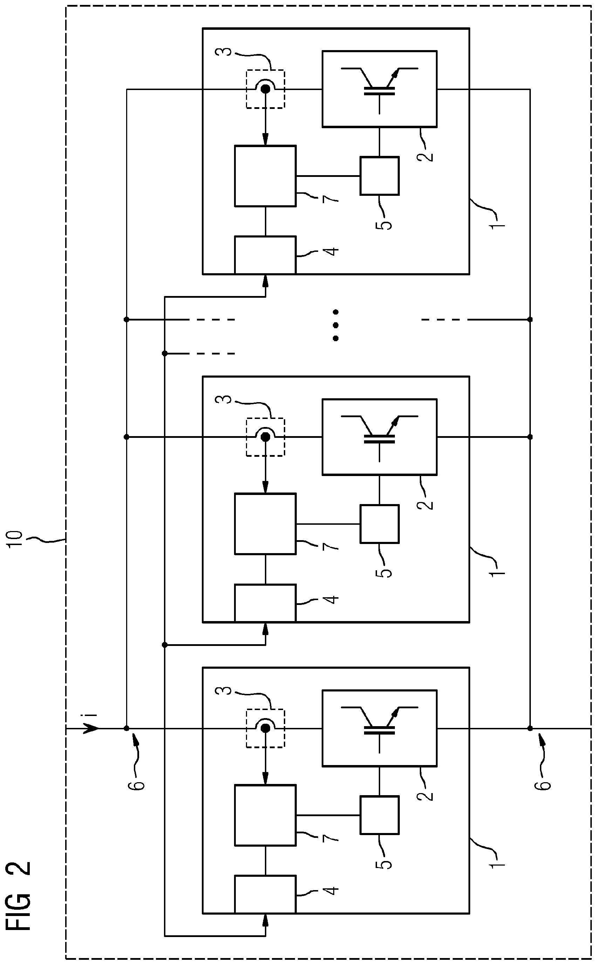

Die FIG 2 zeigt einen elektronischen Schalter 10, der aus einer Vielzahl von parallel angeordneten Schaltmodulen 1 aufgebaut ist. Zum Aufbau eines modularen elektronischen Schalters 10 können zwei oder mehr Schaltmodule 1 verwendet werden. Die einzelnen Schaltmodule entsprechen beispielsweise dem Ausführungsbeispiel der FIG 1. Diese können baugleich sein oder sich unterscheiden. Beispielsweise können sich die Schaltmodule 1 in der Leistungsfähigkeit des Halbleiterschalters 2 unterscheiden. Damit ist es möglich, elektronische Schalter 1 mit unterschiedlichen Schaltströmen mit nur wenigen, parallel angeordneten Schaltmodulen 1 zu realisieren. Dies Schaltmodule 1 sind zum Datenaustausch über ihre Datenschnittstelle 4 miteinander verbunden. Dabei kann die Datenschnittstelle 4 als digitale oder analoge Datenschnittstelle 4 ausgebildet sein. Durch die übertragenen Daten können die Regelungen 7 der einzelnen Schaltmodule 1 die Aufteilung des Stroms i auf die einzelnen Schaltmodule steuern oder regeln. Dabei können verschiedene Optimierungskriterien für die Aufteilung des Stroms i herangezogen werden. Durch die Regelungen 7 wird sichergestellt, dass kein Schaltmodul 1 mit einem unzulässig hohen Strom durchflossen wird.

Dabei kann die Verdrahtung 6 des elektronischen Schalters 10, welche die Halbleiterschalter 2 der Schaltmodule 1 parallel miteinander verbindet, unsymmetrisch, auch als asymmetrisch bezeichnet, ausgeführt sein. So ist beispielsweise die Leitungslänge im dargestellten Ausführungsbeispiel für die Verbindung des linken Schaltmoduls 1 am geringsten und nimmt mit jedem Schaltmodul 1 von links nach rechts zu.

Alternativ zu den in den Figuren 1 und 2 dargestellten Ausführungsbeispielen ist es auch möglich, anstelle der einzelnen Regelungen 7 der jeweiligen Schaltmodule 1 eine zentrale Regelung für den elektronischen Schalter 10 vorzusehen. Ebenso können alternativ die Aufgaben der Regelung 7 durch die Ansteuerschaltung durchgeführt werden. Der Datenaustausch zwischen der zentralen Regelung und den Ansteuerschaltungen 5 kann dann beispielsweise auch über die Datenschnittstelle 4 erfolgen.

## Patentansprüche

1. Elektronischer Schalter (10) mit mindestens zwei Schaltmodulen (1), wobei die Schaltmodule (1) jeweils einen Halbleiterschalter (2) mit einer Ansteuerschaltung (5), einen Stromsensor (3) und eine Datenschnittstelle (4) zur Verbindung mit einem weiteren Schaltmodul (1) aufweisen, wobei die Schaltmodule (1) dazu eingerichtet sind, mittels der Ansteuerschaltung (5) in Abhängigkeit von über die Datenschnittstelle ausgetauschten Daten und in Abhängigkeit von Messwerten des Stromsensors (3) den Durchlasswiderstand des Halbleiterschalters (2) zu verändern, wobei die Schaltmodule (1) derart parallel angeordnet sind, dass die Halbleiterschalter (2) elektrisch parallel angeordnet sind und dass ein Strom (i) durch den elektronische Schalter (10) sich auf die Halbleiterschalter (2) der Schaltmodule (1) aufteilt, wobei die Datenschnittstellen (4) der jeweiligen Schaltmodule (1) miteinander verbunden sind, wobei der elektronische Schalter (10) eingerichtet ist, mittels der Ansteuerschaltungen (5) durch Veränderung des jeweiligen Durchlasswiderstands der Halbleiterschalter (2) eine Aufteilung des Stroms (i) durch den elektronischen Schalter (10) auf die Halbleiterschalter (2) zu steuern und/oder zu regeln,
**dadurch gekennzeichnet, dass** der elektronische Schalter (10) eingerichtet ist, die parallel angeordneten Halbleiterschalter (2) mittels der Ansteuerschaltung (5) synchron zu schalten, insbesondere synchron abzuschalten, und bei einem Wechsel zwischen EIN und AUS sowie einem Wechsel zwischen AUS und EIN im Zeitbereich von 1µs bis 10µs derart im linearen Bereich zu betreiben, dass der Strom durch die jeweiligen Schaltmodule (1) kontrolliert reduziert oder kontrolliert aufgebaut wird.

2. Elektronischer Schalter (10) nach Anspruch 1, wobei der Halbleiterschalter (2) derart ausgebildet ist, einen Strom unabhängig von der Stromflussrichtung durch das Schaltmodul (1) abschalten zu können.

3. Elektronischer Schalter (10) nach einem der Ansprüche 1 oder 2, wobei die Schaltmodule (1) baugleich ausgeführt sind.

4. Elektronischer Schalter (10) nach einem der Ansprüche 1 oder 2, wobei sich die Schaltmodule (1) durch die Leistungsfähigkeit der jeweiligen Halbleiterschalter (2) unterscheiden.

5. Elektronischer Schalter (10) nach einem der Ansprüche 1 bis 4, wobei eine Verdrahtung (6) zur elektrischen Verbindung der Schaltmodule (1) unsymmetrisch ausgeführt ist, wobei die Leitungslänge für die Verbindung eines ersten der Schaltmodule (1) geringer ist als die Leitungslänge eines zweiten der Schaltmodule (1).

6. Verfahren zum Betreiben eines elektronischen Schalters (10) nach einem der Ansprüche 1 bis 5, wobei in Abhängigkeit von über die Datenschnittstelle (4) ausgetauschten Daten und in Abhängigkeit von Messwerten der Stromsensoren (3) der Durchlasswiderstand der Halbleiterschalter (2) derart gesteuert oder geregelt wird, dass sich der Strom (i) durch den elektronischen Schalter (10) derart auf die Halbleiterschalter (2) aufteilt, dass die jeweiligen Halbleiterschalter (2) maximal den jeweils zulässigen Strom führen,
**dadurch gekennzeichnet, dass** die parallel angeordneten Halbleiterschalter (2) mittels der Ansteuerschaltung (5) synchron geschaltet, insbesondere synchron abgeschaltet, werden und bei einem Wechsel zwischen EIN und AUS sowie einem Wechsel zwischen AUS und EIN im Zeitbereich von 1µs bis 10µs derart im linearen Bereich betrieben werden, dass der Strom durch die einzelnen Schaltmodule (1) kontrolliert reduziert oder kontrolliert aufgebaut wird.

7. Verfahren nach Anspruch 6, wobei die Aufteilung des Stroms (i) auf die Halbleiterschalter (2) derart gesteuert oder geregelt wird, dass die Auslastung der Halbleiterschalter (2), insbesondere ein Halbleiterstrom durch die jeweiligen Halbleiterschalter (2), gleich ist.

8. Verfahren nach einem der Ansprüche 6 oder 7, wobei die für Aufteilung des Stroms (i) erforderlichen Parameter ermittelt und gespeichert werden.

9. Verfahren nach einem der Ansprüche 6 bis 8, wobei die jeweiligen Halbleiterschalter (2) maximal der zulässige Strom der jeweiligen Halbleiterschalter (2) mit Hilfe eines Modells kontinuierlich berechnet wird, wobei in das Modell die Verlustleistung oder eine Temperatur des Halbleiterschalters eingeht.

## Claims

1. Electronic switch (10) comprising at least two switching modules (1), wherein the switching modules (1) each comprise a semiconductor switch (2) with a drive circuit (5), a current sensor (3) and a data interface (4) for connecting to a further switching module (1), wherein the switching modules (1) are configured to change the forward resistance of the semiconductor switch (2) by means of the drive circuit (5) depending on data exchanged via the data interface and depending on measurement values of the current sensor (3), wherein the switching modules (1) are arranged in parallel in such a way that the semiconductor switches (2) are arranged electrically in parallel and that a current (i) through the electronic switch (10) is divided among the semiconductor switches (2) of the switching modules (1), wherein the data interfaces (4) of the respective switching modules (1) are connected to one another, wherein the electronic switch (10) is configured to control a division of the current (i) through the electronic switch (10) among the semiconductor switches (2) by open-loop and/or closed-loop control by means of the drive circuits (5) by changing the respective forward resistance of the semiconductor switches (2),
**characterized in that** the electronic switch (10) is configured to synchronously switch, in particular synchronously turn off, the semiconductor switches (2) arranged in parallel by means of the drive circuit (5) and to operate them in the linear region in the time range of 1 µs to 10 µs upon a change between ON and OFF and a change between OFF and ON in such a way that the current through the respective switching modules (1) is reduced in a controlled manner or is built up in a controlled manner.

2. Electronic switch (10) according to Claim 1, wherein the semiconductor switch (2) is designed in such a way as to be able to turn off a current independently of the current flow direction through the switching module (1).

3. Electronic switch (10) according to either of Claims 1 and 2, wherein the switching modules (1) are embodied structurally identically.

4. Electronic switch (10) according to either of Claims 1 and 2, wherein the switching modules (1) differ in the performance of the respective semiconductor switches (2).

5. Electronic switch (10) according to any of Claims 1 to 4, wherein a wiring (6) for electrically connecting the switching modules (1) is embodied asymmetrically, wherein the line length for the connection of a first of the switching modules (1) is shorter than the line length of a second of the switching modules (1) .

6. Method for operating an electronic switch (10) according to any of Claims 1 to 5, wherein depending on data exchanged via the data interface (4) and depending on measurement values of the current sensors (3), the forward resistance of the semiconductor switches (2) is controlled by open-loop or closed-loop control in such a way that the current (i) through the electronic switch (10) is divided among the semiconductor switches (2) in such a way that the respective semiconductor switches (2) maximally carry the respectively permissible current,
**characterized in that** the semiconductor switches (2) arranged in parallel are synchronously switched, in particular synchronously turned off, by means of the drive circuit (5) and are operated in the linear region in the time range of 1 µs to 10 µs upon a change between ON and OFF and a change between OFF and ON in such a way that the current through the individual switching modules (1) is reduced in a controlled manner or is built up in a controlled manner.

7. Method according to Claim 6, wherein the division of the current (i) among the semiconductor switches (2) is controlled by open-loop or closed-loop control in such a way that the capacity utilization of the semiconductor switches (2), in particular a semiconductor current through the respective semiconductor switches (2), is identical.

8. Method according to either of Claims 6 or 7, wherein the parameters required for the division of current (i) are determined and stored.

9. Method according to any of Claims 6 to 8, wherein the respective semiconductor switches (2) maximally the permissible current of the respective semiconductor switches (2) is calculated continuously with the aid of a model, wherein the model incorporates the power loss or a temperature of the semiconductor switch.

## Revendications

1. Commutateur électronique (10) comprenant au moins deux modules de commutation (1), dans lequel les modules de commutation (1) présentent respectivement un commutateur à semi-conducteur (2) avec un circuit de commande (5), un capteur de courant (3) et une interface de données (4) pour la liaison avec un module de commutation (1) supplémentaire, dans lequel les modules de commutation (1) sont conçus, au moyen du circuit de commande (5), pour modifier la résistance directe du commutateur à semi-conducteur (2) en fonction de données échangées par le biais de l'interface de données et en fonction de valeurs de mesure du capteur de courant (3), dans lequel les modules de commutation (1) sont ainsi disposés en parallèle que les commutateurs à semi-conducteur (2) sont disposés parallèles électriquement et qu'un courant (i) à travers le commutateur électronique (10) se répartit sur les commutateurs à semi-conducteur (2) des modules de commutation (1), dans lequel les interfaces de données (4) des modules de commutation (1) respectifs sont reliées entre elles, dans lequel le commutateur électronique (10) est conçu, au moyen des circuits de commande (5), pour commander et/ou réguler une répartition du courant (i) à travers le commutateur électronique (10) sur les commutateurs à semi-conducteur (2) en modifiant la résistance directe respective des commutateurs à semi-conducteur (2),
**caractérisé en ce que** le commutateur électronique (10) est conçu pour commuter de manière synchrone, en particulier couper de manière synchrone, les commutateurs à semi-conducteur (2) agencés en parallèle au moyen du circuit de commande (5), et lors d'un changement entre MARCHE et ARRÊT ainsi que lors d'un changement entre ARRÊT et MARCHE dans la plage temporelle de 1µs à 10us, pour fonctionner dans la plage linéaire de façon à ce que le courant soit réduit de manière contrôlée ou établi de manière contrôlée par les modules de commutation (1) respectifs.

2. Commutateur électronique (10) selon la revendication 1, dans lequel le commutateur à semi-conducteur (2) est conçu de façon à pouvoir couper un courant par le module de commutation (1) indépendamment du sens du courant.

3. Commutateur électronique (10) selon l'une des revendications 1 ou 2, dans lequel les modules de commutation (1) sont de même construction.

4. Commutateur électronique (10) selon l'une des revendications 1 ou 2, dans lequel les modules de commutation (1) se différencient par la puissance des commutateurs à semi-conducteur (2) respectifs.

5. Commutateur électronique (10) selon l'une des revendications 1 à 4, dans lequel un câblage (6) pour la liaison électrique des modules de commutation (1) est conçu de manière asymétrique, dans lequel la longueur de ligne pour la liaison d'un premier des modules de commutation (1) est plus petite que la longueur de ligne d'un deuxième des modules de commutation (1) .

6. Procédé d'exploitation d'un commutateur électronique (10) selon l'une des revendications 1 à 5, dans lequel, en fonction de données échangées par le biais de l'interface de données (4) et en fonction de valeurs de mesure des capteurs de courant (3), la résistance directe des commutateurs à semi-conducteur (2) est ainsi commandée ou régulée que le courant (i) à travers le commutateur électronique (10) se répartit de telle façon sur les commutateurs à semi-conducteur (2) que les commutateurs à semi-conducteur (2) respectifs conduisent au maximum le courant respectivement admis,
**caractérisé en ce que** les commutateurs à semi-conducteur (2) agencés en parallèle sont commutés de manière synchrone, en particulier coupés de manière synchrone, au moyen du circuit de commande (5), et lors d'un changement entre MARCHE et ARRÊT ainsi que lors d'un changement entre ARRÊT et MARCHE dans la plage temporelle de 1µs à 10us, pour fonctionner dans la plage linéaire de façon à ce que le courant soit réduit de manière contrôlée ou établi de manière contrôlée par les différents modules de commutation (1).

7. Procédé selon la revendication 6, dans lequel la répartition du courant (i) sur les commutateurs à semi-conducteur (2) est ainsi commandée ou régulée que la charge des commutateurs à semi-conducteur (2), en particulier un courant de semi-conducteur à travers les commutateurs à semi-conducteur (2) respectif, est égal(e).

8. Procédé selon l'une des revendications 6 ou 7, dans lequel les paramètres nécessaires à la répartition du courant (i) sont calculés et enregistrés.

9. Procédé selon l'une des revendications 6 à 8, dans lequel les commutateurs à semi-conducteur (2) respectifs le courant maximal admis des commutateurs à semi-conducteur (2) respectifs est calculé en continu à l'aide d'un modèle, dans lequel la puissance dissipée ou une température du commutateur à semi-conducteur entre dans le modèle.
